# EUROPÄISCHE PATENTANMELDUNG

(11) **EP 2 003 444 A1**
(43) Veröffentlichungstag der Anmeldung: **17.12.2008**
(21) Anmeldenummer: 07110247.9
(22) Anmeldetag: 14.06.2007
(51) Int. Cl.: G01N 27/414

(54) **Ladungssensitiver Halbleitersensor**

(71) Anmelder: Mettier-Toledo AG, 8606 Greifensee (CH)
(72) Erfinder: Ambacher, Oliver, 98693 Ilmenau (DE); Kittler, Gabriel, 98693 Ilmenau (DE); Ehrismann, Philippe, 8610 Uster (CH); Bernasconi, Markus, 5012 Schönenwerd (CH); Geitz, Clemens, 35041 Marburg (DE); Möbius, André, 8048 Zürich (CH); Demuth, Caspar, 8610 Uster (CH); Lübbers, Benedikt, 98693 Ilmenau (DE); Cimalla, Irina, 98693 Ilmenau (DE)

(57) **Zusammenfassung**

Der ladungssensitive Halbleitersensor, der der Bestimmung von physikalischen und/oder chemischen Eigenschaften, insbesondere der Bestimmung des pH-Werts eines Mediums, einer Flüssigkeit oder eines Gases, dient, weist eine Halbleiterstruktur mit wenigstens einem darin integrierten Transistor auf. Der Transistor weist einen zwischen einem ersten und einem zweiten Anschluss (7,8) liegenden Elektronenkanal (2DEG) auf, der im Grenzbereich einer ersten und einer zweiten Halbleiterschicht (4,5) vorgesehen ist und dessen Leitfähigkeit durch das Potential von Ladungen steuerbar, die einer an die zweite Halbleiterschicht (5) angrenzenden dritten Halbleiterschicht (6) zuführbar sind. Es bestehen wenigstens die erste und zweite Halbleiterschicht (4,5) der Halbleiterstruktur aus Material von Gruppe-III-Nitriden, in das zumindest partiell Atome eines Halbleiterelements der Gruppe-IV, beispielsweise Siliziumatome, eingelagert sind, wodurch die Lichtempfindlichkeit des Sensors reduziert wird.

## Beschreibung

Die vorliegende Erfindung betrifft einen ladungssensitiven; insbesondere einen ionensensitiven Sensor (ISFET) oder einen Chem-FET; mit wenigstens einem Halbleiterelement, der der Bestimmung von physikalischen und/oder chemischen Eigenschaften, insbesondere der Bestimmung des pH-Werts von Medien, wie Fluiden, insbesondere Flüssigkeiten oder Gasen bzw. darin enthaltenen Analyten, dient.

Die vorliegende Erfindung betrifft insbesondere einen ladungssensitiven Sensor mit einem Halbleiterelement, das nach dem Prinzip eines Feldeffekttransistors (FET) arbeitet und vorzugsweise die Struktur eines High Electron Mobility Transistors (HEMT) aufweist.

Ein Feldeffekttransistor ist ein aktives Bauelement, das wie ein spannungsgesteuerter Widerstand arbeitet. Er besitzt drei Elektroden: G (Gate), D (Drain), S (Source). Bei einigen Bauformen wird ein zusätzlicher Anschluss B (Substrat, engl. bulk) nach aussen geführt. Meist ist Bulk aber mit Source verbunden.

An die Stelle des metallischen Gate bei einem konventionellen Feldeffekttransistor tritt beim ladungssensitiven Feldeffekttransistor (beispielsweise einem ISFET) eine ladungssensitive Schicht, die gegebenenfalls über eine Funktionsschicht mit der zu messenden Flüssigkeit in Kontakt gebracht wird. Je nach Zusammensetzung der Flüssigkeit bzw. der Konzentration der darin enthaltenen Analyten werden Ladungen an die ladungssensitive Schicht angelegt, weshalb im leitenden Kanal zwischen Source und Drain Ladungsträger verdrängt oder angereichert werden. Dadurch ändert sich der gemessene elektrische Widerstand zwischen Source und Drain, der die zu bestimmende Eigenschaft des Mediums bzw. die Konzentration der Analyten repräsentiert.

Besonders häufig werden ionensensitive Sensoren (ISFET) verwendet, welche ionische Analyten erfassen. Auf der Technologie von Feldeffekttransistoren basierende ISFET-Sensoren sind beispielsweise in P. Bergveld, "Thirty years of ISFETOLOGY, What happened in the past 30 years and what may happen in the next 30 years", University of Twente, Enschede, 30 Juni 2002 oder in DE 100 62 044 A1 beschrieben.

Die in DE 100 62 044 A1 beschriebenen ISFET-Sensoren basieren auf einem speziellen Feldeffekttransistor, nämlich einem HEMT-Transistor (High Electron Mobility Transistor), der eine Heterostruktur aus Gruppe-III-Nitriden aufweist. Die oberste Schicht der Schichtfolge tritt bei der Messung in direkten Kontakt mit dem zu messenden Medium.

Aus WO 2004/034025 sind Chem-FET-Sensoren bekannt, die Funktionseinheiten aufweisen, die beim Auftreten von Analyten, insbesondere chemischen, biochemischen oder zellularen Substanzen, eine Ladungsänderung erfahren, die in einem detektierbaren Signal resultiert. Als Analyten sind u.a. Enzyme, Proteine, Nukleinsäuren, Glukose, etc. genannt.

Die in WO 2004/034025 beschriebenen Chem-FET-Sensoren weisen Nano-Drähte auf, die als Elektroden dienen, an die die Analyte andocken können. Sofern die Analyte einen Dipolcharakter aufweisen, erfahren die Elektroden eine Ladungsänderung, die beispielsweise von der vorliegenden oder sich ändernden Kettenbildung der Analyte bzw. der Kopplung und Ausrichtung der Dipole abhängt.

Auf die oberste Schicht einer konventionellen Halbleiterstruktur eines Sensors kann zur Messung derartiger Analyte eine Schicht aufgebracht werden, die in eine Wechselwirkung mit Analyten tritt. Die Analyten dringen dabei in der Regel nicht in die Funktionsschicht ein, sondern wechselwirken auf molekularer Ebene mit der Funktionsschicht oder koppeln an diese an.

Alternativ sind Funktionsschichten auf die Halbleiterstruktur auftragbar, die Analyte, selektiv passieren lässt, wodurch deren Ladungen an die tiefer liegende, ladungssensitive Schicht transferiert werden. Gemäss DE 10 062 044 A1 können diese Schichtsysteme z.B. aus so genannten Ionentauschern, wie z. B. Ceolithen, gefertigt sein, die für bestimmte Analyte selektiv durchlässig sind. In diesem Fall treten nur die durchgelassenen Analyte auf die Gate-Fläche bzw. GaN-Fläche des ISFET oder CHEMFET auf und beeinflussen dadurch den n-leitenden Kanal. Zur verbesserten Messung der Leitfähigkeit oder der pH-Werte von Flüssigkeiten kann beispielsweise eine funktionelle Schicht aus einer Keramik auf der Gate-Fläche aufgebracht sein. Eine derartige Keramik kann z.B. ein Protonenleiter sein, wie er beispielsweise unter der registrierten Bezeichnung ORMOCER bekannt ist.

Nachteilig bei den bekannten ISFET-Sensoren ist, insbesondere bei solchen auf Basis von Wide-band-gap Materialien wie zum Beispiel Galliumnitrid, dass diese typischerweise eine hohe Lichtempfindlichkeit aufweisen. Sofern bei Prozessen, in denen ein Medium mittels ISFET-Sensoren überwacht wird, Lichteinflüsse nicht ausgeschlossen werden können, ist daher mit störenden Messabweichungen zu rechnen.

Der vorliegenden Erfindung liegt daher die Aufgabe zugrunde, einen nach dem Prinzip eines Feldeffekttransistors (FET bzw. HEMT) arbeitenden ladungssensitiven Sensor anzugeben, bei dem durch Lichteinwirkungen verursachte Messabweichungen reduziert oder weitgehend vermieden werden.

Diese Aufgabe wird mit einem ladungssensitiven Sensor gelöst, welcher die in Anspruch 1 angegebenen Merkmale aufweist. Vorteilhafte Ausgestaltungen der Erfindung sind in weiteren Ansprüchen angegeben.

Der ladungssensitive Halbleitersensor, der der Bestimmung von physikalischen und/oder chemischen Eigenschaften, insbesondere der Bestimmung des pH-Werts eines Mediums, einer Flüssigkeit oder eines Gases, dient, weist eine Halbleiterstruktur mit wenigstens einem darin integrierten Transistor auf.

Der Transistor weist einen zwischen einem ersten und einem zweiten Anschluss liegenden Elektronenkanal auf, der im Grenzbereich einer ersten und einer zweiten Halbleiterschicht vorgesehen ist und dessen Leitfähigkeit durch das Potential von Ladungen steuerbar, die einer an die zweite Halbleiterschicht angrenzenden dritten Halbleiterschicht zuführbar sind und auf die Ladungsträger im Elektronenkanal einwirken.

Erfindungsgemäss bestehen wenigstens die erste und die zweite Halbleiterschicht der Halbleiterstruktur aus Material von Gruppe-III-Nitriden, wie beispielsweise Galliumnitrid, in das zumindest partiell Atome eines Halbleiterelements der Gruppe-IV, beispielsweise Siliziumatome, eingelagert sind.

Die eingelagerten Siliziumatome stellen schwach gebundene Valenzelektronen zur Verfügung, durch die die Konzentration verfügbarer Ladungsträger im Bereich des Elektronenkanals erhöht wird. Durch die Siliziumdotierung wird das Verhältnis zwischen der Anzahl von Elektronen im Kanal, welche durch die Polarisation der Halbleiterschichten und die Wechselwirkung mit dem Medium erzeugt werden, und die Anzahl der durch die störende Lichteinwirkung erzeugten Elektronen vergrössert, und dadurch der Einfluss der licht-induzierten Ladungsträger verringert. Durch störende Lichteinwirkungen auftretende Messabweichungen werden daher deutlich reduziert, wenn eine genügende Anzahl von Valenzelektronen beispielsweise von eingelagerten Silizium- oder Germaniumatomen zur Verfügung stehen.

Die Galliumatome werden durch Siliziumatome substituiert. Dazu ist hochreines Silizium erforderlich, welches durch Bildung gasförmiger Verbindungen am leichtesten gewonnen werden kann, welche sodann als Dotiergas beispielsweise mittels metallorganischer Gasphasenepitaxie (MOVPE) appliziert werden. Beispielsweise wird Silan (SiH4) verwendet, das mittels eines weiteren Gases, beispielsweise mittels Wasserstoff, stark verdünnt wird, bis das Silizium in der für die Dotierung erforderlichen Konzentration vorliegt. Die Einlagerung der Atome des Halbleiterelements der Gruppe-IV erfolgt vorzugsweise mit einer Teilchendichte von 10¹⁵ cm⁻³ bis 10¹⁹ cm⁻³. Optimale Resultate werden normalerweise bei Teilchendichten von 10¹⁶ cm⁻³ bis 10¹⁸ cm⁻³ erzielt.

Die Halbleiterstruktur kann vorteilhaft nach dem Verfahren der Molekularstrahlepitaxie (MBE), nach dem Verfahren der metallorganischen Gasphasenepitaxie (MOVPE/MOCVD), oder der Hydridgasphasenepitaxie (HVPE) gefertigt werden.

Mittels dieser Verfahren können Halbleiterstrukturen für erfindungsgemässe Sensoren auf einer Substratschicht gefertigt werden, die vorzugsweise aus Saphir (Al₂O₃), Siliziumcarbid (SiC), Zinkoxid (ZnO), Borphosphid (BP), Galliumarsenid (GaAs), Galliumphosphid (GaP) oder Silizium (Si) besteht.

Da beim Auftragen von Gallium-Verbindungen auf das Substrat Gitterfehlanpassungen resultieren und unterschiedliche thermische Dehnungskoeffizienten auftreten, die zu einem Aufreissen der Schichten führen könnte, wird vorzugsweise eine an die Substratschicht anschliessende Nukleations- oder Keimschicht vorzugsweise aus Aluminiumnitrid (AIN) vorgesehen, die beispielsweise eine Schichtdicke von wenigen Nanometern, beispielsweise 5*10⁻⁹ m, bis 50*10⁻⁹ m aufweist.

Anschliessend an die Nukleationsschicht wird die Pufferschicht aus Galliumnitrid (GaN) aufgetragen mit einer Schichtdicke von typischerweise wenigen 10⁻⁶ m bei der Verwendung des MOCVD Verfahrens.

Der Pufferschicht aus Galliumnitrid (GaN) folgt eine Barriereschicht aus Aluminium-Galliumnitrid (AlGaN) mit einer Schichtdicke von typischerweise 5*10⁻⁹ m bis 50*10⁻⁹ m.

Es versteht sich, dass die angegebenen Dimensionen in Abhängigkeit der jeweiligen Anwendungen, der gewählten Materialien und Prozesse sowie der Produktionsmittel und insbesondere in Abhängigkeit der zu realisierenden Eigenschaften der Sensoren in einem weiten Bereich variieren können.

Am verspannten Übergang der ersten und zweiten Halbleiterschicht bzw. der Pufferschicht aus Galliumnitrid (GaN) und der Barriereschicht aus Aluminium-Galliumnitrid (AlGaN) entstehen aufgrund von Polarisationseffekten starke elektrische Grenzflächenladungen. In der Folge werden nahe des Übergangs der beiden Schichten (GaN und AIGaN), normalerweise innerhalb der Pufferschicht (GaN), frei bewegliche Elektronen angereichert, die ein räumlich stark begrenztes Elektronengas bilden, das nur in einer Ebene parallel zum genannten Schichtübergang ausgerichtet ist und daher als 2D-Elektronengas bzw. als 2DEG bezeichnet wird. Das Elektronengas 2DEG bildet dabei den leitenden und steuerbaren Kanal des Feldeffekt-oder HEMT-Transistors.

Unterhalb des Bereichs des Elektronengases 2DEG, typischer weise weniger als 10*10⁻⁹ m beabstandet oder den Bereich des Elektronengases 2DEG gar überdeckend, sind die Gruppe-IV Atome in das Material der Pufferschicht (GaN) eingelagert. Gegebenenfalls sind Gruppe-IV Atome auch zusätzlich oder alternativ in das Material über dem Bereich des Elektronengases 2DEG in das Material der Barriereschicht (AlGaN) eingelagert.

Auf die Barriereschicht aus Aluminium-Galliumnitrid (AlGaN) ist eine Deckschicht oder Kappe aus Galliumnitrid (GaN) aufgetragen, der die Analyte des Mediums zuführbar sind. Die Deckschicht kann auch als Funktionsschicht ausgestaltet sein, die Analyte selektiv passieren lässt oder mit diesen in eine Wechselwirkung tritt.

Die Atome des Halbleiterelements der Gruppe-IV sind daher
(a) innerhalb der Pufferschicht aber unterhalb der dritten Zone bzw. unterhalb des Elektronengases 2DEG; oder
(b) innerhalb der Pufferschicht einschliesslich des Bereichs der dritten Zone bzw. des Elektronengases 2DEG; oder
(c) innerhalb der Pufferschicht und der Barriereschicht, einschliesslich des Bereichs der dritten Zone bzw. des Elektronengases 2DEG

vorzugsweise in wenigstens einem parallel zur dritten Zone ausgerichteten Segment in die entsprechenden Halbleitermaterialien eingelagert.

In einer weiteren vorzugsweisen Ausgestaltung der Erfindung wird die einfallende Strahlung wie folgt neutralisiert. Der Lösungsgedanke ist dabei mit der oben beschriebenen Lösung eng verwandt. Dabei wird der oder werden auf Strahlung empfindlichen Teile des Sensors mit einer konstanten Strahlung im relevanten Bereich des Strahlungsspektrums derart beaufschlagt, dass Änderungen der von aussen einwirkenden Strahlung beispielsweise des sichtbaren Lichts anteilsmässig derart gering werden, dass sie vernachlässigt werden können. Zum Verständnis dieser Lösung stelle man sich einen Raum mit einer Deckenlampe vor, die den Raum optimal ausleuchten kann. Im Raum sei ferner ein optischer Sensor vorhanden, mittels dessen Lichtänderungen erfassbar sind. Wird nun bei ausgeschalteter Deckenlampe ein Streichholz entzündet, so wird durch den optischen Sensor eine starke Lichtänderung gemessen. Wird das Streichholz hingegen bei eingeschalteter Deckenlampe entzündet wird kaum eine Änderung der Lichtintensität gemessen. Durch die Zuschaltung einer Strahlungsquelle kann daher die störende Strahlung vollständig neutralisiert werden. Ein allfälliger konstanter Offset, der durch die Strahlungsquelle bewirkt wird, kann durch einen Nullabgleich leicht korrigiert werden. Bei vielen Anwendungen resultieren durch die Strahlungsquelle keine störenden Einwirkungen auf das Messgut. Bei der Messung beispielsweise von biologischen Substanzen ist hingegen denkbar, dass die Einwirkung einer Strahlung störend sein kann. Die Strahlungsquelle wird in diesen Fällen im Sensor derart angeordnet, dass kein oder nur wenig Licht nach aussen dringt und nur die betreffenden Stellen der Halbleiterstruktur beaufschlagt werden. Dies kann beispielsweise durch die Integration einer Leuchtdiode in die Halbleiterstruktur oder durch das Einsetzen einer Leuchtdiode an passender Stelle im Gehäuse des Sensors geschehen.

Aus US 2007/096120 ist eine LED-Einheit bekannt, die eine epitaktische Struktur mit mehreren Schichten aus Halbleitermaterialien aufweist, mittels derer eine lichterzeugende Region geformt ist, die unter Anlegung von elektrischer Energie Licht erzeugt. Das Substrat ist dabei in einem Wellenlängenbereich des erzeugten Lichts im Wesentlichen transparent. Mittels der offenbarten Lehre, die durch Referenz in die vorliegende Anmeldung eingeschlossen wird, ist es daher vorteilhaft möglich, die Halbleiterstruktur mit einer Lichtquelle zu ergänzen und diese unter Verwendung transparenter Schichten derart einzuschliessen, dass nur die die lichtempfindlichen Zonen der Halbleiterstruktur, nicht jedoch das Medium bestrahlt wird. In US 2007/096120 ist dabei beschrieben, dass die von der Leuchtdiode erzeugte Strahlung aufgrund von Reflektionen an den Schichten der Halbleiterstruktur nur in reduziertem Masse nach aussen gelangen kann, wobei sogar eine totale innere Reflektion auftreten kann. Dieser Effekt, der beim Gegenstand der US 2007/096120 ein Problem darstellt, wird für die vorliegende Erfindung vorteilhaft genutzt, indem die Leuchtdiode in die Halbleiterstruktur integriert und deren Strahlung innerhalb der Halbleiterschichten derart geführt wird, dass möglichst wenig Licht nach aussen dringt.

Ferner kann das Licht gelenkt und/oder gespiegelt werden, was beispielsweise anhand des Auftrags von Metallisierungen leicht möglich ist. Gegebenenfalls wird auch die Strahlungsintensität angepasst, was z.B. durch die Wahl einer bestimmten Versorgungsspannung möglich ist. Diese Versorgungsspannung kann fest eingestellt werden oder auch mittels einer Steuervorrichtung wahlweise einstellbar sein.

Anstelle nur einer Leuchtdiode können auch mehrere Leuchtdioden vorgesehen sein. Die einzelnen Leuchtdioden können gleiche oder unterschiedliche Eigenschaften aufweisen. Ferner können die Leuchtdioden auch wahlweise zu- oder umschaltbar sein, so dass der Sensor an die Umgebung sowie an das Medium angepasst werden kann. Beispielsweise kann durch entsprechende Schaltvorgänge die Intensität und/oder das Spektrum der abgegebenen Strahlung nach Wunsch verändert werden. Die Strahlungsquelle gibt vorzugsweise eine Strahlung im visuellen und oder in einem angrenzenden Spektralbereich ab. Die Intensität der Strahlung liegt beispielsweise in einem Bereich etwa 5*10⁻³ bis 250*10⁻³ cd, vorzugsweise von 120*10⁻³ bis 200*10⁻³ cd oder von 5 bis 50*10⁻³ cd.

Durch die beschriebene Lösung resultieren eine kostengünstige und einfache Herstellung sowie ein äusserst kompakter Aufbau des Sensors. Weitere Ausgestaltungen mit getrennt vorgesehenen Leuchtdioden sind ebenfalls, jedoch mit grösserem Aufwand realisierbar.

Durch die oben beschriebenen Massnahmen gelingt es, durch störende Lichteinwirkungen verursachte Messabweichungen deutlich zu reduzieren. Ferner können die Dynamik des Messsignals und die Steilheit (ΔU_{M} / ΔpH) des Sensors vorteilhaft eingestellt werden. Vollständig lassen sich durch Lichteinwirkungen verursachte Änderungen des Messsignals jedoch nicht vermeiden.

In einer weiteren vorteilhaften Ausgestaltung der Erfindung, die auch unabhängig von der Struktur und Beschaffenheit der verwendeten Transistoren vorteilhaft anwendbar ist, werden daher wenigstens ein aktiver, der Messung der Eigenschaften eines Mediums dienender Transistor und wenigstens ein passivierter Transistor vorgesehen, dessen Deckschicht mit einer transparenten Passivierungsschicht abgedeckt ist. Der aktive Transistor erfasst über die Deck- oder Funktionsschicht Analyte aus dem Medium oder deren Ladungen und ist gleichzeitig der einfallenden Lichtstrahlung ausgesetzt. Der passivierte Transistor ist durch die Passivierungsschicht gegen das Medium abschirmt, wird jedoch ebenfalls durch die einfallende Lichtstrahlung beaufschlagt. Da beide Transistoren in gleichem Masse mit Licht beaufschlagt werden, ändern die Verhältnisse in den leitenden und steuerbaren Kanälen der beiden Transistoren, die als Widerstände dargestellt werden können, diesbezüglich in gleicher Weise. Unterschiede zwischen beiden Transistoren treten hingegen in Abhängigkeit der Konzentration der Analyte im Medium auf, welches nur auf den aktiven Transistor einwirken kann.

Der aktive und der passivierte Transistor, die vorzugsweise identisch aufgebaut sind, sind dabei derart in eine Differenzschaltung, gegebenenfalls in eine Messbrücke eingebunden, dass sich die durch Lichteinwirkungen verursachten Änderungen der Eigenschaften des aktiven und des passivierten Transistors gegenseitig kompensieren.

Die Differenzschaltung kann als Subtrahierer mit wenigstens einem beschalteten Operationsverstärker aufgebaut sein, der zur Messung von Potentialdifferenzen geeignet ist. Die mittels des aktiven und der passivierten Transistors gewonnenen Spannungspotentiale werden dabei vorzugsweise über Impedanzwandler dem invertierenden bzw. dem nicht-invertierenden Eingang des Operationsverstärkers zugeführt, an dessen Ausgang das Differenzsignal abgegeben wird, das normalerweise proportional zur Konzentration der Analyten im Medium ist. Subtrahierer sind beispielsweise in U. Tietze, Ch. Schenk, Halbleiterschaltungstechnik, 11. Auflage, 1. Nachdruck, Springer Verlag, Berlin 1999, Seite 1190-1191 beschrieben.

In einer vorzugsweisen Ausgestaltung wird eine Messbrücke verwendet, mittels der der durch den Lichteinfall verursachte Signalanteil ebenfalls kompensierbar bzw. vom Nutzsignal subtrahierbar ist.

Die Messbrücke weist vorzugsweise einen ersten und einen zweiten Brückenzweig auf, die an einer gemeinsamen Speisespannung anliegen und die je zwei Brückenelemente aufweisen, an deren Verbindungspunkten die Brückenspannung anliegt, welche mit der zu messenden Grösse korrespondiert.

Verschiedene vorteilhafte Ausgestaltungen der Messbrücke sind realisierbar.

In einer ersten vorzugsweisen Ausgestaltung sind im ersten Brückenzweig ein aktiver und ein passivierter Transistor in Serie geschaltet. Im zweiten Brückenzweig sind zwei nicht lichtempfindliche konstante oder auf einen konstanten Wert einstellbare Widerstände in Serie geschaltet. Da die Eigenschaften des n-Kanals des aktiven und des passivierten Transistors in Abhängigkeit von Lichteinwirkungen stets um dasselbe Mass ändern, verbleibt der Mittelabgriff des ersten Brückenzweigs, ebenso wie der Mittelabgriff des zweiten Brückenzweig somit unabhängig von der Lichtweinwirkung auf demselben Spannungspotential, so lange die Konzentration der Analyten, z.B. der Ionen im Medium nicht ändert.

In einer zweiten vorzugsweisen Ausgestaltung sind im ersten Brückenzweig ein aktiver Transistor und ein nicht lichtempfindlicher konstanter oder auf einen konstanten Wert einstellbarer Widerstand in Serie geschaltet und im anderen Brückenzweig ein passivierter Transistor und ein nicht lichtempfindlicher konstanter oder auf einen konstanten Wert einstellbarer Widerstand in derselben Reihenfolge in Serie geschaltet. Zwischen den Mittelabgriffen der beiden Brückenzweige treten daher keine durch Lichteinwirkungen verursachte Spannungsänderungen auf.

Sofern in den Brückenzweigen wenigstens ein regelbarer Widerstand vorgesehen ist, kann der Nullpunkt der Messbrücke in einfacher Weise eingestellt werden.

In einer dritten vorzugsweisen Ausgestaltung sind im ersten Brückenzweig ein aktiver und ein passivierter Transistor in der einen Reihenfolge in Serie geschaltet. Im zweiten Brückenzweig sind ein aktiver und ein passivierter Transistor in der anderen Reihenfolge in Serie geschaltet. Wie in der ersten Ausgestaltung bleiben die Mittelabriffe der Brückenzweige, bei unveränderter Konzentration der Analyte im Medium, somit unabhängig von der Lichteinwirkung stets auf demselben Spannungspotential, da sich alle vier Transistoren hinsichtlich der Lichteinwirkung gleich verhalten. Aufgrund der Verwendung von zwei aktiven Transistoren an den beschriebenen Positionen der Messbrücke treten bei Änderungen der Konzentration der Analyten im Mediums, im Vergleich zur ersten und zweiten Ausgestaltung der Messbrücke, doppelt so hohe Messspannungen zwischen den Mittelabgriffen der beiden Brückenzweige auf.

Die Deckschicht (Cap Layer) des passivierten Transistors ist vorzugsweise mittels einer transparenten Passivierungsschicht beispielsweise aus einem Lötstopplack, aus Monomeren oder Polymeren wie Parylene, Polyimid, oder Polyethylenterephthalat (PET) oder aus polykristallinen Keramikmaterialien wie Zirkoniumoxid, abgedeckt, welche Strahlung gegebenenfalls nur in einem ausgewählten Lichtbereich wie dem Bereich sichtbaren Lichts, passieren lässt und die Deckschicht gegen Analyte abschirmt.

Nachfolgend wird die Erfindung anhand von Zeichnungen näher erläutert. Dabei zeigt:
- Fig. 1: in Schnittdarstellung einen erfindungsgemässen ladungssensitiven Sensor mit einer Transistorstruktur, die auf einem Substrat beispielsweise aus Saphir (Al₂O₃) aufgebaut ist und die im Wesentlichen aus einer auf einer Nukleationsschicht (AlN) gewachsenen und mit Siliziumatomen dotierten Pufferschicht (GaN) und einer Barriereschicht (AlGaN) besteht, der über eine Deckschicht Analyten aus dem Medium zuführbar sind;
- Fig. 2: a) einen Ausschnitt der Halbleiterstruktur von Figur 1, mit Siliziumatomen, die in einer Schicht unmittelbar unterhalb der durch die Pufferschicht (GaN) und die Barriereschicht (AlGaN) gebildeten Elektronengasebene 2DEG Ebene eingelagert sind;
b) einen Ausschnitt der Halbleiterstruktur von Figur 1, mit Siliziumatomen, die in einem Bereich eingelagert sind, der die Elektronengasebene 2DEG einschliesst und beidseitig davon Zonen der Pufferschicht (GaN) und der Barriereschicht (AlGaN) überlappt;
- Fig. 3: die Halbleiterstruktur von Figur 1 in räumlicher Darstellung;

- Fig. 4: einen erfindungsgemässen ladungssensitiven Sensor mit einer Halbleiterstruktur, in die eine Leuchtdiode integriert ist;
- Fig. 5: einen weiteren erfindungsgemässen ladungssensitiven Sensor mit einer Halbleiterstruktur, in die eine Leuchtdiode integriert ist;
- Fig. 6: einen erfindungsgemässen ladungssensitiven Sensor mit einer separaten Strahlungsquelle;
- Fig. 7: eine Differenzschaltung, der die Signale von zwei steuerbaren Widerständen bzw. den steuerbaren n-Kanälen von zwei Transistoren T1, T2, von denen der erste der Erfassung von Ladungen aus dem Medium und der zweite, der mittels einer transparenten Schicht passiviert ist, der Erfassung störender Strahlungseinflüsse dient;
- Fig. 8: eine Messbrücke mit vier steuerbaren Widerständen bzw. den steuerbaren n-Kanälen von vier Transistoren T1, ..., T4, von denen zwei Transistoren (T1, T4) der Erfassung von Ladungen aus dem Medium dienen und zwei Transistoren (T2, T3), die je mittels einer transparenten Schicht passiviert sind, der Erfassung störender Strahlungseinflüsse dienen;
- Fig. 9: die Oberseite einer Halbleiterstruktur, in die zwei aktive und zwei mittels Parylene passivierte Transistoren vorzugsweise entsprechend der Halbleiterstruktur von Figur 1 integriert und zu einer Messbrücke gemäss Figur 8 zusammengeschaltet sind; und
- Fig. 10: einen Schnitt durch eine Halbleiterstruktur mit einem aktiven Transistor, der durch das einfallende Licht und die Analyten im Medium gesteuert wird, und einem passivierten Transistor, der nur durch das einfallende Licht gesteuert wird.

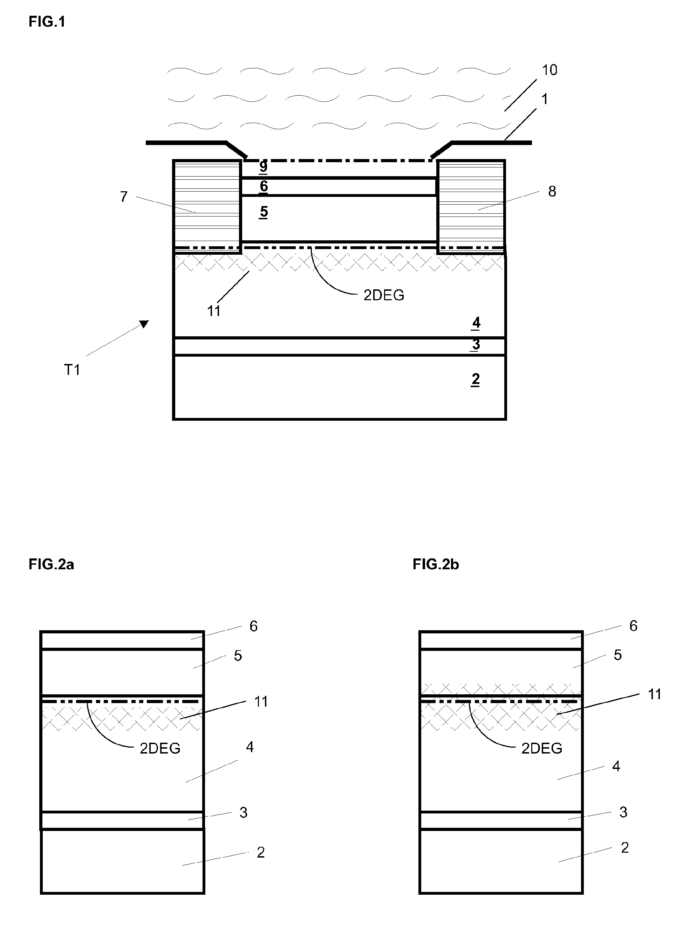

Figur 1 zeigt einen erfindungsgemässen ladungssensitiven Sensor, der in einem Gehäuse 1 angeordnet ist, mit einer Transistorstruktur, die auf einem Substrat 2 beispielsweise aus Saphir (Al₂O₃), Siliziumcarbid (SiC), Zinkoxid (ZnO), Borphosphid (BP), Galliumarsenid (GaAs), Galliumphosphid (GaP) oder Silizium (Si) aufgebaut ist. Diese Materialien werden als Ersatz für Nitrid-Volumenmaterial verwendet und sollten eine hexagonale Kristallstruktur, eine geringe Gitterfehlanpassung, einen geringen Unterschied der thermischen Ausdehnung zu GaN, und eine hohe chemische und thermische Stabilität aufweisen. Eine hohe thermische Leitfähigkeit des Substrats 2, wie sie bei der Verwendung in Leistungstransistoren erwünscht ist, ist dabei von untergeordneter Bedeutung. In der Nitridepitaxie wird zumeist Saphir (Al₂O₃) oder Siliziumcarbid (SiC) verwendet.

Da beim Auftragen von Gallium-Verbindungen auf die genannten Substrate zumeist nicht tolerierbare Gitterfehlanpassungen und zu hohe Unterschiede der thermischen Dehnungskoeffizienten resultieren, wird vorzugsweise eine an die Substratschicht 2 anschliessende Nukleations- oder Keimschicht vorzugsweise aus Aluminiumnitrid (AIN) vorgesehen, die beispielsweise eine Schichtdicke von 5*10⁻⁹ m bis 50*10⁻⁹ m aufweist.

Die Gitterfehlanpassungen einerseits zwischen dem Substrat 2 und der Nukleationsschicht 3 und andererseits zwischen der Nukleationsschicht 3 und der folgenden Pufferschicht 4, vorzugsweise aus GaN, werden dadurch auf ein tolerierbares Mass reduziert. Auf die Nukleationsschicht 3 kann auch eine Zwischenschicht aus AlGaN aufgetragen werden, wodurch die Spannungen weiter reduziert werden.

Auf die Nukleationsschicht 3 ist eine Pufferschicht 4 aus Galliumnitrid (GaN) aufgetragen, an die eine Barriereschicht 5 aus Aluminium-Galliumnitrid (AlGaN) anschliesst.

Bei der Pufferschicht 4 und der darüberliegenden Barriereschicht 5 handelt es sich um so genannte pseudomorphe Heterostrukturen, zwischen denen eine geringe Gitterfehlanpassung erwünscht ist, die zu einer Verspannung führt. Hierdurch kommt es zur Ausbildung von piezoelektrisch induzierten, internen Flächenladungen am Heteroübergang und in der Folge zur Influenz des zweidimensionalen Elektronengases 2DEG, das knapp unterhalb des Heteroübergangs noch innerhalb der Pufferschicht 4 normalerweise auch dann resultiert, wenn dem Gate bzw. der Deckschicht 6 des Transistors noch keine Ladungen aus dem Medium zugeführt wurden.

Beidseits des Bereichs des Elektronengases 2DEG ist die Pufferschicht 4 abgesenkt, so dass das Elektronengas 2DEG unterbrochen bzw. zu zwei Zonen des Transistors geführt ist, die mit dem Source-Anschluss 7 bzw. dem Drain-Anschluss 8 kontaktiert sind.

Nur wenig unterhalb des Bereichs des Elektronengases 2DEG sind in einem quaderförmigen Segment der Pufferschicht 4 Siliziumatomen eingelagert, die schwach gebundene Valenzelektronen zur Verfügung stellen, durch die die Konzentration verfügbarer Ladungsträger im Bereich des Elektronengases erhöht wird. Durch die Siliziumdotierung wird das Verhältnis zwischen der Anzahl von Elektronen im Kanal, welche durch die Polarisation der Halbleiterschichten und die Wechselwirkung mit dem Medium erzeugt werden, und der Anzahl der durch die störende Lichteinwirkung erzeugten Elektronen vergrössert, so dass sich der Einfluss der licht-induzierten Ladungsträger verringert. Die Auswirkungen von Lichteinwirkungen auf die Messergebnisse werden daher deutlich reduziert. Besonders deutliche Verbesserungen konnten bei der Einlagerung von Siliziumatomen mit einer Teilchendichte von 10¹⁵ cm⁻³ bis 10¹⁹ cm⁻³ erzielt werden.

Auf der Barriereschicht 5 ist eine Deckschicht 6 oder Cap Layer aus GaNaufgetragen, welche die Halbleiterstruktur schützt und deren Verhalten stabilisiert. Die Deckschicht 6 kann zusätzlich mit einer Funktionsschicht 9 abgedeckt sein, die nur bestimmte Analyte, wie Ionen, passieren lässt oder mit diesen in eine Wechselwirkung tritt. Die Deckschicht 6 und die Funktionsschicht 9 können auch zusammengefasst werden.

In Figur 1 ist ferner das Medium M mit darin vorhandenen ionischen Analyte schematisch gezeigt, welches über die Deckschicht 6 auf den Transistor einwirkt.

Der ladungssensitive Halbleitersensor von Figur 1 weist drei funktionell zusammenwirkende Halbleiterschichten 4, 5, 6 und zwei elektrische Anschlüsse auf, welche den SOURCE-Anschluss 7 und den DRAIN-Anschluss 8 des Transistors bilden.

Zwischen dem SOURCE- und DRAIN-Anschluss 7, 8 liegt ein Elektronenkanal 2DEG, der im Grenzbereich einer ersten Halbleiterschicht 4 und einer zweiten Halbleiterschicht 5 vorgesehen ist und dessen Leitfähigkeit durch das Potential von Ladungen steuerbar ist, die einer an die zweite Halbleiterschicht 5 angrenzenden dritten Halbleiterschicht 4 zuführbar sind.

Der Elektronenkanal 2DEG bildet daher einen steuerbaren Widerstand R_{T}, der Strom vom Source-Anschluss 7 zum Drain-Anschluss 8 führt. Oberhalb der zweiten Halbleiterschicht 5, bzw. der Barriere-Schicht (AlGaN), ist dritte Halbleiterschicht 6 vorgesehen, der Ladungen aus dem Medium 10 zuführbar sind. Durch diese Ladungen wird die Anzahl der im Elektronenkanal 2DEG vorhanden freien Ladungsträger gesteuert. Sofern zahlreiche Analyten mit positiven Ladungen zur Deckschicht gelangen, entsteht ein elektrisches Feld, welches zahlreiche Ladungsträger, insbesondere die Valenzelektronen der eingelagerten Siliziumatome, in den Bereich des Elektronenkanals 2DEG bewegt, wo sie für den Stromtransport zur Verfügung stehen.

Figur 2a zeigt einen Ausschnitt der Halbleiterstruktur von Figur 1, mit Siliziumatomen, die in einer Schicht 11 unmittelbar unterhalb der durch die Pufferschicht 4 und die Barriereschicht 5 gebildeten Elektronengasebene 2DEG eingelagert sind. Diese Zone der Einlagerung von Siliziumatomen 11 ist besonders vorteilhaft, da die Valenzelektronen der Siliziumatome durch elektrische Felder leicht in die Elektronengasebene 2DEG transferiert werden können, durch gegebenenfalls einwirkende Lichtstrahlung jedoch nicht beeinflusst werden.

Figur 2b zeigt einen Ausschnitt der Halbleiterstruktur von Figur 1, mit Siliziumatomen, die in einem Bereich eingelagert sind, der die Elektronengasebene 2DEG einschliesst und beidseitig davon Zonen der Pufferschicht 4 und der Barriereschicht 5 überlappt.

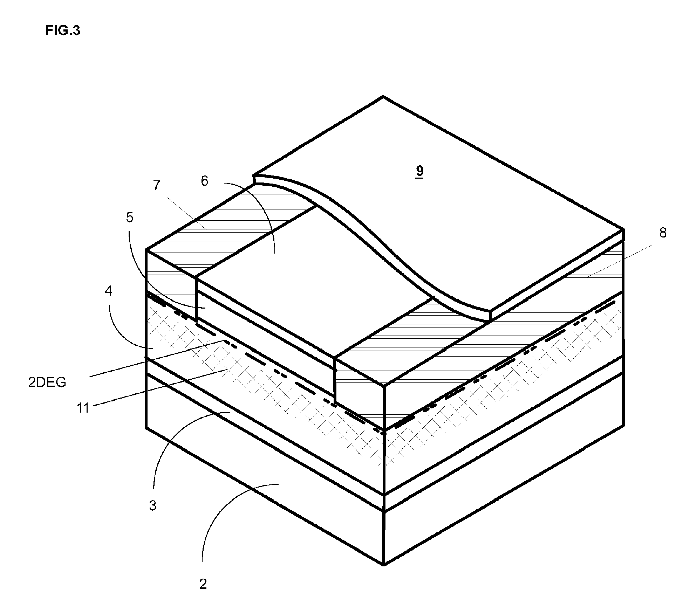

Figur 3 zeigt die Halbleiterstruktur von Figur 1 in räumlicher Darstellung. Auf die an der Pufferschicht 4 beidseits des Elektronengases 2DEG vorgesehenen Schultern werden die Kontaktierungen 7, 8 aufgebaut. Ferner ist eine weitere auf der Deckschicht 6 aufliegende funktionelle Schicht 9 gezeigt, die als Funktionsschicht oder Passivierungsschicht ausgebildet werden kann, welche wie hier gezeigt die gesamte Oberfläche der Halbleiterstruktur und die Kontakte 7, 8 bedecken kann.

Zur verbesserten Messung der Leitfähigkeit oder der pH-Werte von Flüssigkeiten kann beispielsweise eine funktionelle Schicht 12 aus einer Keramik auf der Deckschicht 6 vorgesehen sein. Eine derartige leitende Keramik kann z.B. ein Protonenleiter sein, wie er beispielsweise unter dem Namen ORMOCER ® bekannt ist. D.h., es ist möglich, eine funktionale Schicht aufzubringen, die für die Analyten selektiv ist.

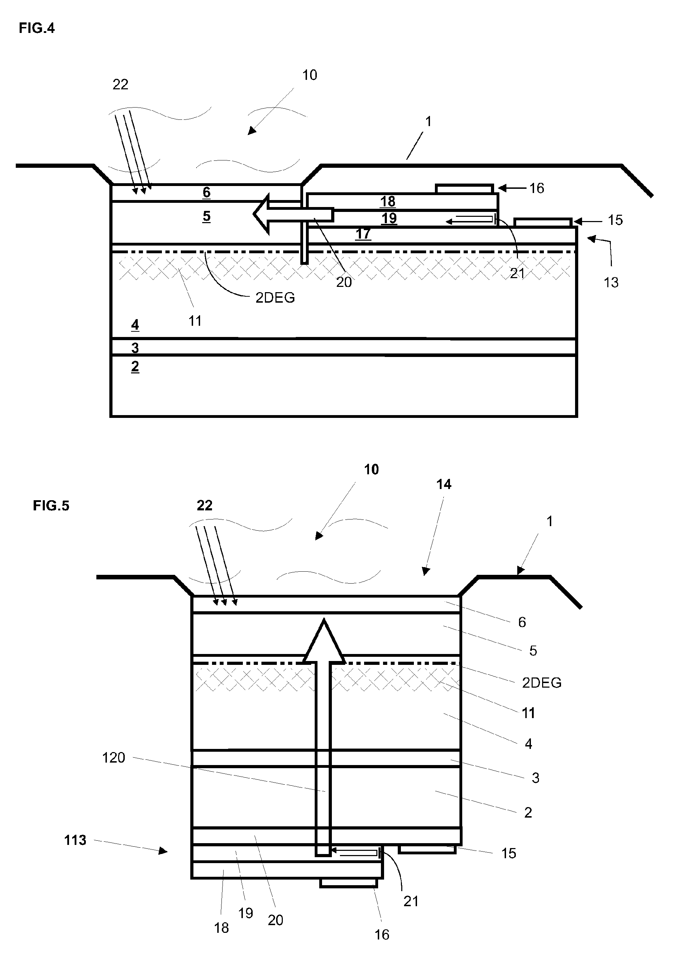

Figur 4 zeigt einen erfindungsgemässen ladungssensitiven Sensor mit einer Halbleiterstruktur gemäss Figur 1, die erweitert und durch eine in die Halbleiterstruktur integrierte Leuchtdiode 13 ergänzt wurde. Der Sensor ist durch ein Gehäuse 1 abgeschlossen, welches ein Fenster 14 aufweist, durch das das Medium 10 der Messschicht bzw. der Deckschicht 6 der Halbleiterstruktur zuführbar ist. Die Halbleiterstruktur kann auch in anderer Weise und ohne Silizium-dotierte Schichten 12 aufgebaut sein. Die Integration der (wenigstens einen) Leuchtdiode 13 ist besonders vorteilhaft, da sie ebenfalls auf GaN-Basis und somit mit derselben Technologie wie der Sensor realisiert werden kann.

Die Leuchtdiode 13 besteht aus zwei mit elektrischen Kontakten 15, 16 versehenen Schichten 17, 18 zwischen denen eine Region 19 vorgesehen ist, durch die die Strahlung 20 abgegeben wird, wie es in der Figur 4 durch den Pfeil angedeutet wird. Die Strahlung 20 wird dabei in Richtung des ladungsempfindlichen Sensors, vorzugsweise in die Deckschicht 6 und/oder in die Barriere-Schicht 5 abgegeben. Wie in US 2007/096120 beschrieben ist es dabei möglich, die Strahlung durch Reflexionen innerhalb der Schichten zu leiten, ohne dass diese nach aussen dringt. Dazu werden die Berechungsindizes der aneinander angrenzenden Materialien entsprechend gewählt. Ferner können die Schichtgrenzen durch Metallisierungen 21 verspiegelt werden, die die in Figur 4 gezeigt ist.

Die von der Leuchtdiode 13 abgegebene konstante Strahlung 20, die beispielsweise im sichtbaren und/oder einem angrenzenden Spektralbereich liegt, ist dabei um ein Vielfaches höher, als die Strahlung 22 aus der Umgebung, weshalb deren Einfluss während des Betriebs der Leuchtdiode vernachlässigt werden kann.

Figur 5 zeigt eine weitere Ausgestaltung eines Sensors mit einer Halbleiterstruktur in die eine LED 113 integriert ist. Der Aufbau der LED 113 entspricht im Wesentlichen dem bereits in der Figur 4 beschriebenen LED 13, allerdings ist hier die LED 113 auf der mediumsabgewandten Seite der Halbleiterstruktur direkt auf dem Substrat 2 erzeugt worden. Die von der LED 113 ausgesandte Strahlung 120 durchstrahlt die gesamte Halbleiterstruktur. Diese Ausgestaltung ist besonders vorteilhaft, wenn die Halbleiterstruktur im Wesentlichen optisch transparent ist, wie es insbesondere bei GaN-Strukturen gegeben ist.

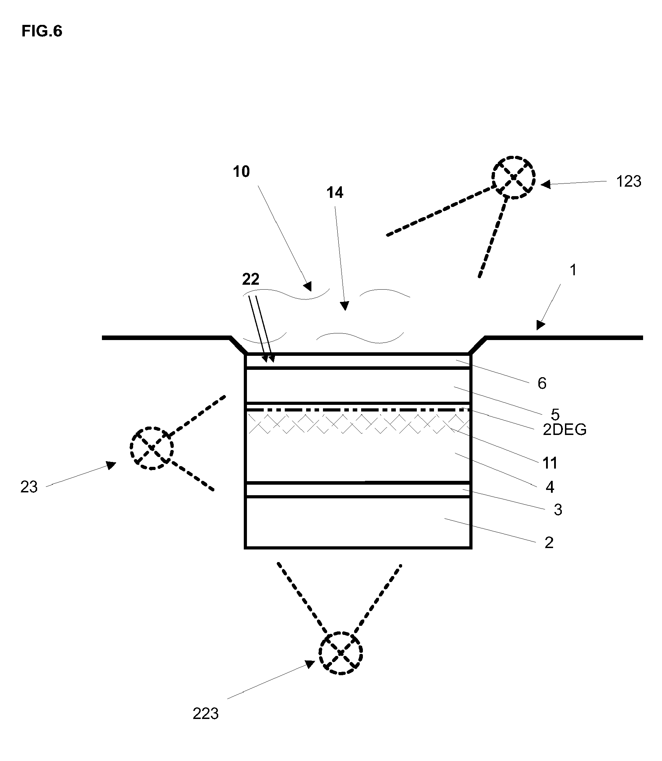

Selbstverständlich kann die Halbleiterstruktur auch durch eine externe Lichtquelle 23, 123, 223 beleuchtet werden, wie es in Figur 6 gezeigt ist. Die Lichtquellen 23, 223 deuten einige verschieden Positionen an, an denen die Lichtquelle im Gehäuse 1 angeordnet werden kann. Weiterhin ist es auch möglich die Lichtquelle 123 im Messmedium 10 und damit ausserhalb des Sensorgehäuses 1 anzuordnen. Als Lichtquellen 23, 123, 223 bieten sich vor allem verschiedene LED an.

Die im Zusammenhang mit den Figuren 4 bis 6 beschriebene Strahlungsquelle 13, 23, 123, 223 können unabhängig von der Ausgestaltung für alle strahlungsempfindlichen Sensoren vorteilhaft eingesetzt werden.

Bei den nachfolgend beschrieben Ausgestaltungen der Erfindung werden die Einflüsse der einfallenden Strahlung durch die Verarbeitung in verschiedener Weise gewonnener Signale korrigiert. Dabei wird ein Anteil des Messsignals, der durch die aus der Umgebung einfallende Strahlung verursacht wurde, mittels eines zusätzlich gewonnenen Signals kompensiert, das nur von der einfallenden Strahlung, nicht aber von der Konzentration der Analyten im Medium abhängt.

Dazu wird eine transparente Passivierungsschicht auf die Deckschicht wenigstens eines Transistors aufgetragen um diesen gegen die Einwirkung der Analyten zu isolieren. Die transparente Passivierungsschicht, die aus einem Lötstopplack, Monomeren oder Polymeren wie Parylene, Polyimid oder Polyethylenterephthalat (PET) oder aus polykristallinen Keramikmaterialien wie Zirkoniumoxid bestehen kann, lässt hingegen die einfallende Strahlung, gegebenenfalls nur in einem ausgewählten Lichtbereich wie dem Bereich sichtbaren Lichts, passieren, so dass von diesem ein Signal abgegeben wird, das proportional zum einfallenden Licht ist. Der wenigstens eine passivierte Transistor wird nun derart in eine Messschaltung eingebunden, dass das Störsignal vom "rohen" Messsignal subtrahiert wird und nur noch ein zur Konzentration der Analyten korrespondierendes Messsignal verbleibt.

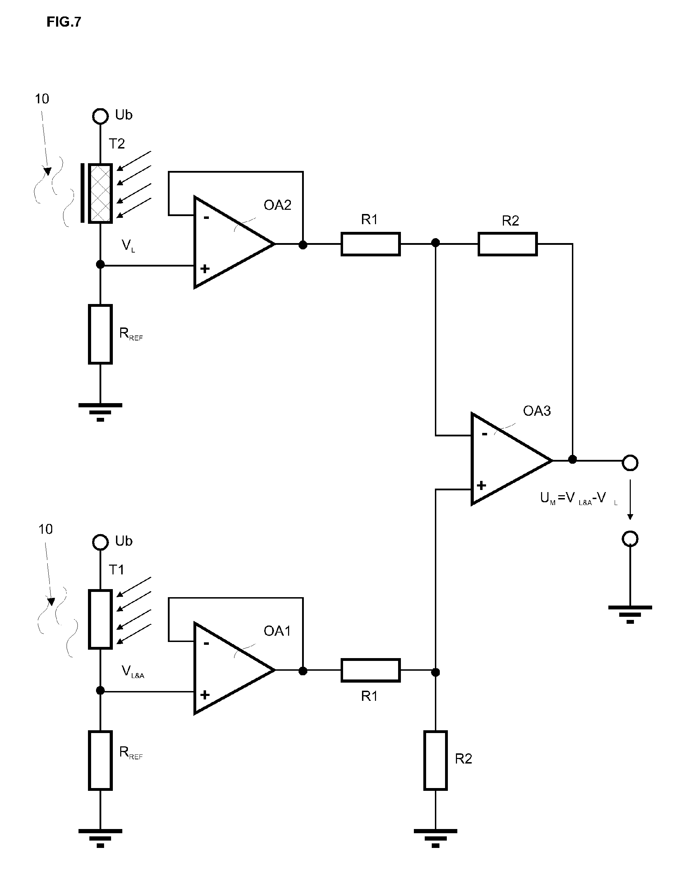

Figur 7 zeigt eine derartige Messschaltung, die als Differenzschaltung bzw. als Subtrahierer aufgebaut ist. Im unteren Zweig wird ein zu den Analyten und zum Lichteinfall korrespondierendes Messsignal V_{L&A} mittels eines nicht-passivierten Transistors T1 gewonnen. Im oberen Zweig wird ein zum Lichteinfall korrespondierendes Messsignal V_{L} mittels eines passivierten Transistors T1 gewonnen. Die Transistoren T1, T2 sind als Widerstände gezeigt, deren Wert von den vorliegenden Messgrössen abhängt. Durch die Transistoren T1, T2 fliesst daher ein von den jeweiligen Messgrössen abhängiger Strom von einer Spannungsquelle über je einen Referenzwiderstand R_{REF} gegen Erde. Das an den Referenzwiderstand R_{REF} anfallende Potential V_{L&A} bzw. V_{L} wird je einem als Impedanzwandler beschalteten Operationsverstärker zugeführt OA1 bzw. OA2, dessen Ausgang über einen Widerstand R1 mit dem nicht-invertierenden bzw. invertierenden Eingang eines mittels Widerständen R2 als Subtrahierer beschalteten weiteren Operationsverstärker OA3 anliegt. Am Ausgang des Subtrahierers liegt das nur noch zur Konzentration der Analyten korrespondierende Messsignal UM an. Dabei gilt:
U_{M} = R2/R1 (V_{L&A} - V_{L})

Besonders vorteilhaft können passivierte und nicht-passivierte Transistoren auch in eine Messbrücke eingebunden werden.

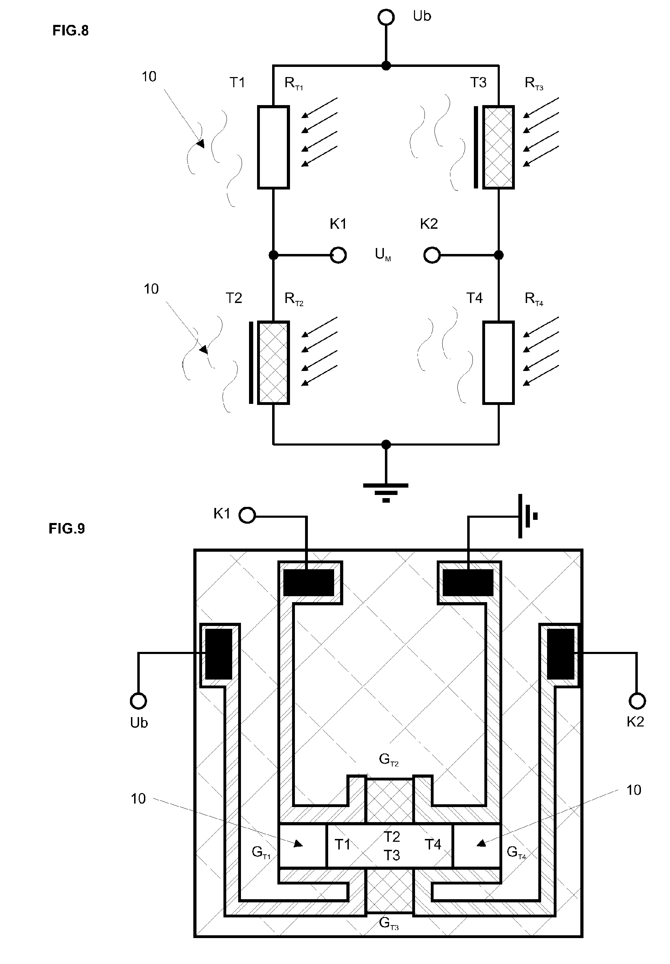

Figur 8 zeigt eine Messbrücke mit vier steuerbaren Widerständen R_{T1}, R_{T2}, R_{T3}, R_{T4} bzw. den steuerbaren n-Kanälen von vier vorzugsweise mittels einer Haibleiterstruktur gemäss Figur 1 realisierten Transistoren T1, T2, T3, T4; von denen zwei (T1, T4) zur Erfassung von Ladungen aus dem Medium vorgesehen und zwei (T2, T3) mittels einer transparenten Schicht, beispielsweise einer Paryleneschicht passiviert sind.

Die Messbrücke weist einen ersten und einen zweiten Brückenzweig auf, die einerseits an einer gemeinsamen Speisespannung Ub und andererseits an Masse anliegen. Die Brückenzweige weisen je zwei Brückenelemente R_{T1}, R_{T2} bzw. R_{T3}, R_{T4} auf, an deren Verbindungspunkten die Brückenspannung U_{M} anliegt.

In der gezeigten vorzugsweisen Ausgestaltung sind im ersten Brückenzweig die gesteuerten Kanäle eines aktiven Transistors R_{T1} und eines passivierten Transistors R_{T2} in der einen Reihenfolge in Serie geschaltet. Im zweiten Brückenzweig sind die gesteuerten Kanäle eines passivierten Transistors R_{T3} und eines aktiven Transistors R_{T4} in der anderen Reihenfolge in Serie geschaltet.

Alle Transistoren T1, T2, T3, T4 sind für einfallendes Licht in gleicher Weise empfindlich, so dass die Messbrücke unabhängig vom Lichteinfall stets im Gleichgewicht bleibt bzw. nur dann aus dem Gleichgewicht gerät, wenn das Medium den aktiven Transistoren T1 und T4 Ladungen zuführt und deren Kanäle R_{T1}, R_{T4} aufgrund der zugeführten Ladungen verändert werden. Wie in Figur 8 schematisch gezeigt ist, sind die Deckschichten der passivierten Transistoren T2 und T3 mit einer transparenten Schicht, beispielsweise einer Paryleneschicht abgedeckt. Parylene und Verfahren für das Auftragen von Parylene auf einen Wafer sind beispielsweise in US 5'536'322 beschrieben.

Figur 9 zeigt die Oberseite einer Halbleiterstruktur, in die zwei aktive und zwei mittels Parylene passivierte Transistoren T1, T4 bzw. T2, T3, vorzugsweise entsprechend der Halbleiterstruktur von Figur 1 integriert und mittels Kontaktbahnen zu einer Messbrücke gemäss Figur 8 zusammengeschaltet sind.

Auf der Oberfläche der Halbleiterstruktur sind vier Deckschichten (Cap Layers) G_{T1}, G_{T2}, G_{T3}, G_{T4} gezeigt, welche je einen Steuereingang eines darunter liegenden Transistors T1, T2, T3, T4 bilden. Die Deckschichten G_{T2}, G_{T3} der Transistoren T2, T3 sind mittels transparenter Parylenebeschichtung elektrisch isoliert, dem Lichteinfall jedoch in gleicher Weise ausgesetzt, wie die Deckschichten G_{T1}, G_{T4} der aktiven Transistoren T1, T4.

Die Verkapselung und Kontaktierung des Sensors erfolgt mit bekannten Massnahmen, wobei darauf zu achten ist, dass insbesondere die elektrischen Kontaktierungen zuverlässig vor dem zu messenden Medium geschützt werden.

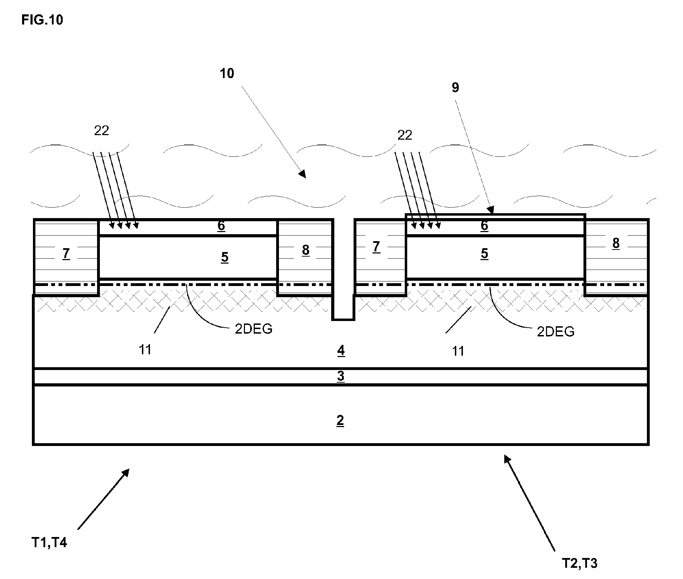

Figur 10 zeigt schematisch einen Schnitt durch einen aktiven Transistor T1 (T4) und einen mittel der Paryleneschicht passivierten Transistor T2 (T3) der Halbleiterstruktur von Figur 9. Wie aus Figur 10 ersichtlich ist, können alle Transistoren in gemeinsamen Arbeitsprozessen simultan gefertigt werden. Lediglich für das Auftragen der Paryleneschichten sind für die zu passivierenden Transistoren separate Prozessschritte notwendig.

### Bezugszeichenliste

- 1: Gehäuse
- 2: Substrat
- 3: Nukleationsschicht
- 4: Pufferschicht / 1. Halbleiterschicht
- 5: Barriereschicht / 2. Halbleiterschicht
- 6: Gate / Deckschicht / 3. Halbleiterschicht
- 7: Source-Anschluss
- 8: Drain-Anschluss
- 9: funktionelle Schicht (Passivierungsschicht /Funktionsschicht)
- 10: Medium
- 11: Silizium-Dotierung
- 13, 113: Leuchtdiode
- 14: Fenster in 1
- 15: elektrischer Kontakt
- 16: elektrischer Kontakt
- 17: Schicht
- 18: Schicht
- 19: Region
- 20, 120: Strahlung
- 21: Metallisierung
- 22: Strahlung aus der Umgebung
- 23, 123, 223: Lichtquelle
- 2DEG: Elektronenkanal
- GT₁, G_{T2}, G_{T3}, G_{T4}: Deckschicht
- K1: Source-Anschluss
- K2: Drain-Anschluss
- OA1, OA2, OA3: Operationsverstärker
- R1, R2: elektrischer Widerstand
- R_{T1}, R_{T2}, R_{T3}, R_{T4}: Brückenelement
- T1, T2, T3, T4: Transistor

- Ub: Speisespannung
- UM: Messsignal / Brückenspannung
- V_{L}: Messsignal des Lichteinfalls
- V_{L&A}: Messsignal des Analyten und des Lichteinfalls

## Patentansprüche

1. Ladungssensitiver, insbesondere ionensensitiver Halbleitersensor zur Bestimmung von physikalischen und/oder chemischen Eigenschaften, insbesondere zur Bestimmung des pH-Werts eines Mediums bzw. zur Messung von Analyten einer Flüssigkeit oder eines Gases, mit einer Halbleiterstruktur mit wenigstens einem Transistor, umfassend einen zwischen einem ersten und einem zweiten Anschluss (7, 8) liegenden Elektronenkanal (2DEG), der im Grenzbereich einer ersten Halbleiterschicht (4) und einer zweiten Halbleiterschicht (5) vorgesehen ist und dessen Leitfähigkeit durch das Potential von Ladungen steuerbar ist, die einer an die zweite Halbleiterschicht (5) angrenzenden dritten Halbleiterschicht (6) zuführbar sind, **dadurch gekennzeichnet, dass** wenigstens die erste und die zweite Halbleiterschicht (4, 5) der Halbleiterstruktur aus Material von Gruppe-III-Nitriden bestehen, in das zumindest partiell Atome eines Halbleiterelements der Gruppe-IV eingelagert sind.

2. Ladungssensitiver Halbleitersensor nach Anspruch 1, **dadurch gekennzeichnet**, die Halbleiterelemente der Gruppe-IV Silizium oder Germanium sind.

3. Ladungssensitiver Halbleitersensor nach Anspruch 1 oder 2, **dadurch gekennzeichnet, dass** die Halbleiterstruktur nach dem Verfahren der Molekularstrahlepitaxie (MBE), nach dem Verfahren der metallorganischen Gasphasenepitaxie (MOVPE/MOCVD), oder der Hydridgasphasenepitaxie (HVPE) gefertigt ist.

4. Ladungssensitiver Halbleitersensor nach einem der Ansprüche 1-3, **dadurch gekennzeichnet, dass** die Halbleiterstruktur umfasst
a. eine Substratschicht vorzugsweise aus Saphir (Al₂O₃), Siliziumcarbid (SiC), Zinkoxid (ZnO), Borphosphid (BP), Galliumarsenid (GaAs), Galliumphosphid (GaP) oder Silizium (Si);
b. vorzugsweise eine an die Substratschicht anschliessende Nukleationsschicht (3) gegebenenfalls aus Aluminiumnitrid;
c. eine als erste Halbleiterschicht (4) dienende Pufferschicht aus Galliumnitrid;
d. eine als zweite Halbleiterschicht (5) dienende Barriereschicht aus Aluminium-Galliumnitrid und
e. eine als dritte Halbleiterschicht (6) dienende Messschicht oder Deckschicht aus Galliumnitrid, der die Analyte oder zumindest die Ladungen der Analyte gegebenenfalls via eine anliegende Funktionsschicht zuführbar sind.

5. Ladungssensitiver Halbleitersensor nach Anspruch 4, **dadurch gekennzeichnet, dass** der Elektronenkanal (2DEG) innerhalb der Pufferschicht durch ein in zwei Dimensionen ausgerichtetes Elektronengas (2DEG) gebildet ist, das gegebenenfalls nur im Zustand einer Inversionslage präsent ist.

6. Ladungssensitiver Halbleitersensor nach einem der Ansprüche 1-5, **dadurch gekennzeichnet, dass** die Atome des Halbleiterelements der Gruppe-IV
a. innerhalb der ersten Halbleiterschicht (4) aber unterhalb des Elektronenkanals (2DEG); oder
b. innerhalb der ersten Halbleiterschicht (4) einschliesslich des Elektronenkanals (2DEG); oder
c. innerhalb der ersten und der zweiten Halbleiterschicht (4, 5),
vorzugsweise in wenigstens einem parallel zum Elektronenkanal (2DEG) ausgerichteten Segment in die entsprechenden Halbleitermaterialien eingelagert sind.

7. Ladungssensitiver Halbleitersensor nach einem der Ansprüche 1-6, **dadurch gekennzeichnet, dass** die Atome des Halbleiterelements der Gruppe-IV in einer Anzahl im Bereich von 10¹⁵ cm⁻³ bis 10¹⁹ cm⁻³ in der Halbleiterstruktur eingelagert sind.

8. Ladungssensitiver Halbleitersensor zur Bestimmung von physikalischen und/oder chemischen Eigenschaften, insbesondere zur Bestimmung des pH-Werts eines Mediums, einer Flüssigkeit oder eines Gases, insbesondere nach einem der Ansprüche 1-7, mit einer Halbleiterstruktur mit wenigstens einem aktiven Transistor (T1), der über die Deck- oder Funktionsschicht Analyten aus dem Medium erfasst, **dadurch gekennzeichnet, dass** die Halbleiterstruktur wenigstens einen passivierten Transistor (T2) aufweist, dessen Deck- oder Funktionsschicht mit einer transparenten Passivierungsschicht abgedeckt ist und der zusammen mit dem aktiven Transistor (T1) derart in eine Differenzschaltung, vorzugsweise in eine Messbrücke eingebunden ist, dass durch Strahlungseinwirkungen verursachte Änderungen der Eigenschaften des aktiven und des passivierten Transistors ohne Einfluss auf das Ausgangssignal (UM) der Messschaltung bleiben.

9. Ladungssensitiver Halbleitersensor nach Anspruch 8, **dadurch gekennzeichnet, dass** die Messbrücke einen ersten und einen zweiten Brückenzweig aufweist, die an einer gemeinsamen Speisespannung (Ub)anliegen und die je zwei Brückenelemente aufweisen, an deren Verbindungspunkten die Brückenspannung (UM) anliegt, und
a. **dass** im ersten Brückenzweig ein aktiver und ein passivierter Transistor (T1, T2) in Serie geschaltet und dass im zweiten Brückenzweig zwei nicht lichtempfindliche konstante oder auf einen konstanten Wert einstellbare Widerstände in Serie geschaltet sind; oder
b. **dass** im ersten Brückenzweig ein aktiver Transistor (T1) und ein nicht lichtempfindlicher konstanter oder auf einen konstanten Wert einstellbarer Widerstand in Serie geschaltet und dass im zweiten Brückenzweig ein passivierter Transistor (T2) und ein nicht lichtempfindlicher konstanter oder auf einen konstanten Wert einstellbarer Widerstand in derselben Reihenfolge in Serie geschaltet sind; oder
c. **dass** im ersten Brückenzweig ein aktiver und ein passivierter Transistor (T1, T2) in der einen Reihenfolge in Serie geschaltet und dass im zweiten Brückenzweig ein aktiver und ein passivierter Transistor (T4, T3) in der anderen Reihenfolge in Serie geschaltet sind.

10. Ladungssensitiver Halbleitersensor nach Anspruch 8 oder 9, **dadurch gekennzeichnet, dass** die transparente Passivierungsschicht, die aus einem Lötstopplack, Monomeren oder Polymeren wie Parylene, Polyimid oder Polyethylenterephthalat (PET) oder aus polykristallinen Keramikmaterialien wie Zirkoniumoxid besteht, die einfallende Strahlung, gegebenenfalls nur in einem ausgewählten Lichtbereich wie dem Bereich sichtbaren Lichts, passieren lässt.

11. Ladungssensitiver Halbleitersensor nach einem der Ansprüche 1 bis 10, **dadurch gekennzeichnet, dass** die Transistoren eine HEMT-Struktur aufweisen und/oder dass der Halbleitersensor ein Gehäuse (G) aufweist, welches die Halbleiterstruktur mit Ausnahme der Messschicht mediumsdicht umschliesst.

12. Ladungssensitiver Halbleitersensor zur Bestimmung von physikalischen und/oder chemischen Eigenschaften, insbesondere zur Bestimmung des pH-Werts eines Mediums, einer Flüssigkeit oder eines Gases, insbesondere nach einem der Ansprüche 1 -11, mit einer Halbleiterstruktur mit wenigstens einem aktiven Transistor (T1), der über die Deck- oder Funktionsschicht Analyten aus dem Medium erfasst, **dadurch gekennzeichnet, dass** wenigstens eine Strahlungsquelle (LED), vorzugsweise eine Leuchtdiode vorgesehen ist, mittels der wenigstens einer der Schichten der Halbleiterstruktur eine Strahlung zuführbar ist.

13. Ladungssensitiver Halbleitersensor nach einem der Ansprüche 1 bis 10, **dadurch gekennzeichnet, dass** die Strahlungsquelle (LED) eine Strahlung im visuellen und oder in einem angrenzenden Spektralbereich abgibt und/oder dass die Strahlungsquelle (LED) eine Strahlung mit einer Intensität von etwa 5*10⁻³ bis 250*10⁻³ cd, vorzugsweise von 120*10⁻³ bis 200*10⁻³ cd abgibt.

14. Ladungssensitiver Halbleitersensor nach Anspruch 12 oder 13, **dadurch gekennzeichnet, dass** die wenigstens eine Strahlungsquelle (LED) in die Halbleiterstruktur integriert ist und vorzugsweise aus Material der Gruppe-III-Nitrid besteht oder/die dass Strahlungsquelle (LED) als diskreter Baustein innerhalb des Gehäuses (G) angeordnet ist.
